# EUROPEAN PATENT APPLICATION

(11) **EP 1 323 850 A1**
(43) Date of publication of application: **02.07.2003**
(21) Application number: 02258649.9
(22) Date of filing: 16.12.2002
(51) Int. Cl.: C25D 3/38, C25D 5/18, C25D 7/12, H01L 21/288, H01L 21/768, H05K 3/42

(54) **Electroplating method of printed circuit with pulsed current density**

(30) Priority: 18.12.2001 JP 2001384970
(71) Applicant: Shipley Co. L.L.C., Marlborough, MA 01752 (US)
(72) Inventor: Kusaka, Masaru, Kitaadachi-gun, Saitama 362-0806 (JP); Tsuchida, Hideki, Hasuda-shi, Saitama, 349-0127 (JP)
(74) Representative: Kent, Venetia Katherine

(57) **Abstract**

An electroplating method not that is especially suited for the filling of vias is provided. In this method, a current is applied in a forward method for a set period of time and then reversed for a set period of time. This method utilizes a rest time either before or after or both before and after the reverse current period.

## Description

### Background of the Invention

This invention pertains generally to the field of electroplating. In particular, that present invention relates to electrolytic copper plating.

There has been a growing demand for higher density and thinner printed circuit boards in response to greater high performance and miniaturization of electronic devices, beginning with personal computers. One means responding to such demands is to use a multilayer printed circuit board (build-up printed circuit board) produced using the build-up method of forming a pattern for each layer and laminating successive layers.

In recent years, a method for completely filling micro via holes (hereafter sometimes called "MVH") with a conductor and electrically connecting adjacent layers of a build-up printed circuit board using such MVHs has been developed for such build-up printed circuit boards. This method, called via-filling, can increase the effective surface area of the printed circuit board and obtain adequate electrical connections even in a MVH having a smaller diameter compared to plating only the inner wall of MVH by prior art methods, and is effective for miniaturizing and increasing the density of printed circuit boards.

Methods published as build-up methods include the method of filling MVHs with a conductive paste using a printing method, the method of selectively building up electroless plating by activating only a conductive layer on the floor of MVHs, and methods using electroplating

Conductive pastes are a mixture of organic substances, however, and a low conductivity compared to pure metals, have difficulty difficulty forming adequate electrical connections in small-diameter MVH, and is not an effective method for miniaturizing and increasing the density of printed circuit boards. Moreover, filling by the printing method requires packing a viscous paste into holes that are impassable due to their small diameter, and has the difficulty of filling holes completely without leaving voids due to the viscosity of the paste. The method of using electroless plating is superior to the conductive paste method on the point that the substance filling the MVH is a highly conductive metallic deposit, but productivity suffers due to a slow plating speed. For example, the plating speed using a general-purpose high-speed electroless copper plating bath is about 3 µm/hr, but filling blind via holes (hereafter sometimes called "BVH") that are typically 100 µm in diameter and 100 µm deep with copper using this bath takes 30 hours or longer, making this extremely poor in terms of commercial productivity.

Because electroplating can substantially reduce time compared to electroless plating, electroplating is expected to be applied to MVH. When depositing a metal over the entire inner surface of a MVH, however, the plating speed near the floor inside the MVH must be faster than the plating speed at the opening in order to fill the MVH with metal without leaving voids. If the plating speed near the floor is the same or slower than the plating speed at the opening, the MVH is not filled or the opening becomes clogged before the MVH is completely filled with metal, leaving voids inside the via hole. In either case, the MVH is inadequate for practical application. Therefore, filling conditions must be strictly controlled to enable the optimum plating of metal for filling micro via holes.

When using a prior art electroless plating bath to accelerate the plating speed near the floor inside MVH, direct-current electrolysis is generally used as a condition of electrolysis. The method of using periodic reverse ("PR") electrolysis alternating the cathode and the anode is also known, but this has an extremely long cycle of several seconds to several tens of seconds, and is not able to satisfactorily control the plating speed of metal.

In addition, the filled surface is not flat, producing an indented shape at the center of via. As a result, when filled to an adequate height, the deposit on the outside of via becomes thick, which causes great inconvenience during later treatments and is economically undesirable.

One method for improving via filling, disclosed in Japanese Unexamined Patent Application No. 2000-68651, is the method of applying electrolytic copper plating using a plating bath containing a particular compound containing sulfur ions and a PPR (pulse periodic reverse) current. However, the invention disclosed by this patent application controls adsorption and desorption of the particular compound containing sulfur ions to the substrate, but requires stricter control of plating conditions to fill micro via holes having a high aspect ratio.

### Summary of the Invention

Reflecting on the situation outlined above, this invention is to offers a novel electroplating method. Although the electroplating method of this invention is especially ideal for filling via, it is not limited to this, and also obtains satisfactory results in various types of general-purpose electroplating.

This invention provides an electroplating method wherein a current is applied for a cycle of 1 to 50 milliseconds (msec) positive electrolysis time, 0.2 to 5 msec reverse electrolysis time, and 0.1 to 20 msec rest time. The special characteristics of this invention are switching the cathode and the anode by a short cycle on the order of msec, and inserting a rest time on the order of msec. Accordingly, this invention provides a method of electroplating a metal layer on a substrate including contacting the substrate with a metal electroplating bath and applying sufficient current density to deposit a desired metal layer, wherein the current density is applied for a cycle of 1 to 50 msec positive electrolysis time, 0.2 to 5 msec reverse electrolysis time and 0.1 to 20 msec rest time.

### Brief Description of the Drawing

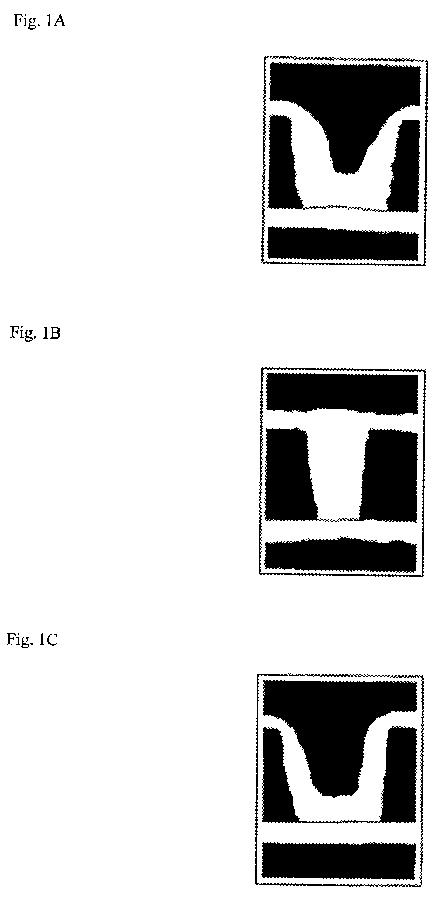

Figs. 1A and 1B are a schematic diagram showing a cross-section of a via plating according to the invention.

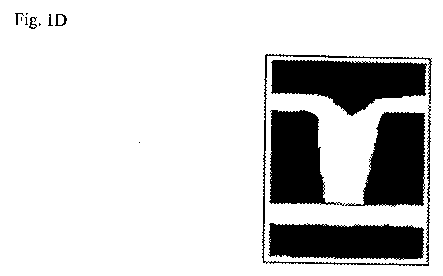

Figs. 1C and 1D are a schematic diagram showing a cross-section of a via plating using a comparative method.

### Detailed Description of the Invention

"Positive electrolysis time" means the time during which electrolysis is applied using the plating object as a cathode, and "reverse electrolysis time" means the time during which electrolysis is applied using the plating object as an anode. "Rest time" means the time during which electrolysis is not applied.

The positive electrolysis time, reverse electrolysis time, and rest time can be changed according to plating conditions such as the opening diameter of the depression to be filled, the aspect ratio, and the type of metal used for filling.

Positive electrolysis time is typically performed from 1 to 50 msec, preferably 5 to 30 msec, and more preferably 10 to 20 msec. Reverse electrolysis time is typically performed from 0.2 to 5 msec, preferably 0.2 to 2 msec, and more preferably 0.2 to 1 msec. Rest time is typically from 0.1 to 20 msec, preferably 0.5 to 5 msec, and more preferably 0.5 to 1 msec.

Positive electrolysis is performed at a current density of preferably 0.1 to 20 A/dm², and more preferably 0.1 to 10 A/dm². Reverse electrolysis is performed at a current density of preferably 0.1 to 200 A/dm², and more preferably 0.1 to 100 A/dm².

The rest time may be inserted during the change from positive electrolysis to reverse electrolysis or during the change from reverse electrolysis to positive electrolysis, and may be inserted during both times. It is considered that inserting such a rest time produces a particularly satisfactory filling result by supplying metallic ions for plating inside the via.

As used herein, the ratio of current density during positive electrolysis to current density during reverse electrolysis is referred to as the F/R ratio. That is, the level of reverse electrolysis current density, R, when positive electrolysis current density, F, is 1 is the F/R ratio, and is lower when F/R = 1/1 than when F/R = 1/2. The F/R ratio can be optimized as desired, but is preferably in a range from 1/0.5 to 1/10, and more preferably from 1/0.5 to 1/1. While other F/R ratios may be used, too low an F/R ratio prevents adequate desorption of grain refiner adsorbed near the openings of blind via holes. As a result, the plating speed of the metal deposit near the floor of blind via holes cannot be faster than the plating speed at the opening, and satisfactory filling cannot be obtained. Too high an F/R ratio causes the metal deposit already deposited to de-plate, resulting in an undesirable lengthening of the time required to fill blind via holes

The method of this invention is useful for filling depressions having a high aspect ratio, such as via holes, with metal. The method of this invention can be used to fill holes having an opening diameter of 100 micrometers and an aspect ratio of 1 or greater, typically 3 or greater, and especially 5 or greater.

This invention can be applied to all metals capable of being electrodeposited, including, without limitation, copper, nickel, gold, silver, palladium, tin, lead, platinum, chromium, zinc, cadmium, iron, aluminum, and alloys of these such as solder.

This invention will be described below for the case of copper plating. However, this is only by way of an example, and this invention can be used in the same way for plating other metals.

This invention is used, for example, when filling blind via holes by copper plating. The copper plating solution during this is typically a copper sulfate plating solution, and preferably contains a grain refiner.

The grain refiner is typically a compound having the structure -X-S-Y-, where X and Y are independently atoms selected from hydrogen, carbon, sulfur, nitrogen, and oxygen atoms, and X and Y can be the same only when both are carbon atoms. More typically, X and Y are independently atoms selected from of hydrogen, carbon, nitrogen, and sulfur atoms. Even more typically, X and Y are independently atoms selected from hydrogen, carbon, and sulfur atoms. Moreover, S in the above formula -X-S-Y- indicates a valency of two, but does not mean a valency of two as far as the X and Y atoms, and the atoms represented by X and Y can be bonded to any other desired atoms depending on their valency. For example, when X is hydrogen, this becomes the structure H-S-Y-.

More typically, the grain refiner is a compound having a sulfonic acid group or a group that is an alkali metal salt of sulfonic acid. One or more of the sulfonic acid group or alkali metal salt of same can be present in each molecule. Even more typically, the grain refiner is a compound having the -S-CH₂O-R-SO₃M structure or a compound having the -S-R-SO₃M structure, where M is a hydrogen or alkali metal atom, and R is an alkyl group containing 3 to 8 carbon atoms. Examples of suitable grain refiners include, but are not limited to, compounds having the following formulae (1) to (6), where a and b are integers from 3 to 8, and M is hydrogen or an alkali metal:
(1) M-SO₃-(CH₂)ₐ-S-(CH₂)_{b}-SO₃-M;
(2) M-SO₃-(CH₂)ₐ-O-CH₂-S-CH₂-O-CH₂-SO₃-M;
(3) M-SO₃-(CH₂)ₐ-S-S-CH₂-S-CH₂-SO₃-M;
(4) M-SO₃-(CH₂)ₐ-O-CH₂-S-S-CH₂―(CH₂)_{b}-SO₃-M;
(5) M-SO₃-(CH₂)ₐ-S-C(=S)-S―(CH₂)_{b}-SO₃-M; and
(6) M-SO₃-(CH₂)ₐ-O-CH₂-S-C(=S)-S-CH₂-O-(CH₂)_{b}-SO₃-M.

Grain refiners are generally called brighteners and are used to improve the appearance of the deposited metal film. However, this invention also includes grain refiners used for other purposes so long as they offer a comparable active effect. The grain refiner may be used alone or in admixtures.

Grain refiners can be used in an amount of from 0.1 to 100 mg/L, and preferably 5 to 10 mg/L. When grain refiners are used for purposes other than to improve the appearance of the plated metal film, the suitable amount of grain refiner is a simple matter that can be easily determined as appropriate by persons skilled in the art.

The electrolytic copper plating solution used in this invention typically contains a surface active agent. The surface active agent can be any desired standard surface active agent normally used as an additive in electrolytic copper plating solutions. Preferably, the surface active agent is a polyether containing at least five intramolecular ether oxygen atoms. Examples of this type of surface active agent are compounds having the following structures (7) to (9), but are not limited to these:
(7) HO -(CH₂-CH₂-O)ₐ-H (where a = an integer from 5 to 500);
(8) HO -(CH₂-CH(CH₃)-O)ₐ-H (where a = an integer from 5 to 200); and
(9) HO -(CH₂-CH₂-O)ₐ-(CH₂-CH(CH₃)-O)_{b}-(CH₂-CH₂-O)_{c}-H (where a and c are integers, a + c is an integer from 5 to 250, and b is an integer from 1 to 100).

The surface active agent used in this invention may be used alone or as a mixture of two or more. Surface active agents used in this invention can be used in an amount of from 0.05 to 10 g/L, and preferably from 0.1 to 5 g/L. While less than 0.05 g/L concentration may be used in the plating solution, such low concentration may cause pin-holes in the deposited metal film due to inadequate moisturizing effect. While greater than 10 g/L may be used, such high concentration is economically undesirable because it hardly provides any commensurate improvement in effect.

When a copper sulfate plating solution is used, the solution is aqueous and contains as a basic composition sulfuric acid, copper sulfate, and a water-soluble chlorine compound. The plating solution can be any conventional copper sulfate plating solution without restrictions.

The concentration of sulfuric acid in the copper sulfate plating solution is typically from 30 to 400 g/L, and preferably from 170 to 210 g/L. While less than 30 g/L sulfuric acid concentration may be used, such low concentration reduces the conductivity of the plating bath. While greater than 400 g/L sulfuric acid may be used, such high concentration may prevent the copper sulfate from dissolving in the plating bath and may lead to copper sulfate sediment formation.

The concentration of copper sulfate in the copper sulfate plating solution is typically from 20 to 250 g/L, and preferably from 60 to 180 g/L. It will be appreciate by those skilled in the art that less than 20 g/L copper sulfate concentration may be used but may have an inadequate supply of copper ions for the substrate to be plated. Greater than 250 g/L copper sulfate may be used but is difficult to dissolve.

The water-soluble chlorine compound contained in the copper sulfate plating solution can be any compound without restrictions so long as it provides chloride ions in the desired concentration. Examples of water-soluble chlorine compounds include hydrochloric acid, sodium chloride, potassium chloride, and ammonium chloride, but are not limited to these. The water-soluble chlorine compound may be used alone or as a mixture of two or more.

The concentration of the water-soluble chlorine compound contained in the copper sulfate plating solution, expressed as concentration of chloride ions, is typically from 10 to 200 mg/L, and preferably 30 to 80 mg/L. Less than 10 mg/L concentration of chloride ions may be used, but additives such as grain refiners or surface active agents may be less effective.

The substrate used in the electroplating method of this invention can be composed of any desired material and shape so long as it can withstand the conditions of the electroplating method and a metal layer can be deposited on it. Examples of substrate materials include resins, ceramics, and metals, but are not limited to these. For example, this method is ideally used for printed circuit board substrates or semiconductor wafers such as silicon wafers. Because the electroplating method of this invention is especially superior for filling via holes, the substrate used in this invention may be a printed circuit board or wafer having through-holes and/or via holes.

Examples of resins used as substrates include, without limitation, thermoplastic resins, including polyethylene resins such as high-density polyethylene, medium-density polyethylene, branching low-density polyethylene, straight-chain low-density polyethylene, or super high-molecular-weight polyethylene; polyolefin resins such as polypropylene resin, polybutadiene, polybutene resin, polybutylene resin, or polystyrene resin; halogenated resins such as polyvinyl chloride resin, polyvinylidene chloride resin, polyvinylidene chloride-polyvinyl chloride copolymer resin, chlorinated polyethylene, chlorinated polypropylene, or tetrafluoroethylene; AS resins; ABS resins; MBS resins; polyvinyl alcohol resins; polyacrylic ester resins such as methyl polyacrylate; polymethacrylic ester resins such as methyl polymethacrylate; methyl methacrylate-styrene copolymer resin; maleic anhydride-styrene copolymer resin; polyvinyl chloride resin; cellulose resins such as cellulose propionate resin or cellulose acetate resin; epoxy resins; polyimide resins; polyamide resins such as nylons; polyamide imide resins; polyallylate resins; polyether imide resins; polyether ether ketone resins; polyethylene oxide resins; polyester resins such as PET resin; polycarbonate resins; polysulfone resins; polyvinyl ether resins; polyvinyl butyral resins; polyphenylene ether resins such as polyphenylene oxide; polyphenylene sulfide resins; polybutylene terephthalate resins; polymethyl pentene resins; polyacetal resins; vinyl chloride-vinyl acetate copolymers; ethylene-vinyl acetate copolymers; ethylene-vinyl chloride copolymers; and copolymers and blends of these; thermosetting resins, including epoxy resins; xylene resins; guanamine resins, diallyl phthalate resins; vinyl ester resins; phenolic resins, unsaturated polyester resins; furan resins; polyimide resins; polyurethane resins, maleic acid resins; melamine resins; and urea resins; and mixtures of these. Preferred resins are epoxy resins, polyimide resins, vinyl resins, phenolic resins, nylon resins, polyphenylene ether resins, polypropylene resins, fluorinated resins, and ABS resins. More preferred resins are epoxy resins, polyimide resins, polyphenylene ether resins, fluorinated resins, and ABS resins. Even more preferred resins are epoxy resins and polyimide resins. In addition, resins substrates may be comprised of a single resin or several resins. The resin substrate may also may be a composite having another resin coated or laminated on the substrate. Moreover, resin substrates that can be used in this invention are not limited to resin molded products, but may be resin composites by way of reinforcing materials, such as materials reinforced by fiberglass between resins, or resin films formed on substrates comprised of other raw materials such as ceramics, glasses, or metals.

Ceramics that can be used as resin materials include oxide ceramics such as alumina (Al₂O₃), steatite (MgO·SiO₂), forsterite (2MgO·SiO₂), mullite (3Al₂O₃·SiO₂), magnesia (MgO), spinel (MgO·Al₂O₃), and beryllia (BeO), non-oxide ceramics such as aluminum nitride or silicon carbonate, and low-temperature sintered ceramics such as glass ceramics, but are not limited to these.

The part of the substrate supplied to the electroplating method of this invention to be plated is subjected to conductive treatment before electroplating. For example, when filling MVH with metal by electroplating using the present method, the inner surface of the MVH is first made conductive. This conductive treatment can be any of a wide variety of conductive treatments. Examples of conductive treatments include, but are not limited to, electroless plating, direct plating, conductive grain adsorption treatment, or gas-phase plating.

The plating temperature (solution temperature) in the present method of this invention is set as appropriate for the type of plating bath used, but is typically from 10°C to 40°C and preferably from 20°C to 30°C.

Any suitable anode can be used in the present electroplating method depending on the type of metal to be plated. Either a soluble anode or an insoluble anode can be used. For example, for copper plating, a phosphated copper anode can be used as a soluble anode, or an anode of a material such as iridium oxide, platinum-clad titanium, platinum, graphite, ferrite, titanium coated with zinc dioxide and a platinic element oxide, or stainless teel can be used as an insoluble anode. Other suitable anodes will be apparent to those skilled in the art.

In the plating method of this invention, preferably, air or oxygen is passed through the plating solution to increase the concentration of dissolved oxygen in the plating solution. Although not wishing to be bound by in theory, dissolved oxygen in the plating solution is considered to decrease the concentration of compounds having the structure -X-S-. A preferred method for increasing the concentration of dissolved oxygen in the plating solution is bubbling air or oxygen through the plating solution. Such bubbling may be by agitating the plating solution, or bubbling unrelated to agitation. In addition, bubbling to increase the concentration of dissolved oxygen in the plating solution may be performed during electroplating or when electroplating is suspended.

There is no objection to agitation in the present method, and agitation is preferred to supply metal ions and additives evenly to the surface to be plated. Air agitation or a jet spray can be used for the agitation method. Air agitation is preferred from the standpoint of increasing the concentration of dissolved oxygen in the plating solution. Even when agitation by a jet spray agitation is used, preferably, air agitation is also used. Furthermore, open-change filtration or reflux filtration can also be used, and reflux filtration of the plating solution by a filter device is especially preferred. Doing this makes the temperature of the plating solution uniform, and can also remove matter such as dirt or sediment in the plating solution.

The present method produces a composite material having a metal layer on a substrate. Vias can be filled without voids using the present method without causing clumps in the metal layer of the composite material.

Although the case of copper plating was described above, other metals are plated in the same way as described above. In this case, the method of this invention can be implemented using any desired standard plating solution. The electroplating solution during this can be any conventional electroplating composition without restrictions. Moreover, the components of the basic electroplating composition can be changed, concentrations can be changed, or additives can be added as appropriate so long as the purposes of this invention are achieved.

This invention will be explained in detail by the following working example, but this working example is no more than an example, and does not in any way limit the scope of this invention.

| | Working Example |
|---|---|
| CuSO₄·5H₂O | 250 g/L |
| H₂SO₄ | 150 g/L |
| Cl⁻ | 60 mg/L |
| SPS | 2 mg/L |
| nonionic surface active agent | 200 mg/L |
| | |
| Note: JEFFOX WL-5000, an Oxilan methyl polymer-Oxilan monobutyl ether manufactured by Texaco Chemical Company, was used as the nonionic surface active agent. | |
| | |
| PPR Electrolysis Conditions current density | 0.5 A/dm² |
| F/R ratio | 1/2 |
| positive electrolysis time | 10 msec |
| reverse electrolysis time | 0.5 msec |
| rest time | 1 msec |
| temperature | 20°C |
| time | 90 minutes |

The rest time was inserted after reverse electrolysis.

A schematic diagram showing cross-sections of via is shown in Figures 1A and 1B.

Moreover, the diameter of the via was 50 micrometers (Fig. 1A) and 30 micrometers (Fig. 1B), and the thickness of the insulating layer was 40 micrometers.

### Comparative Example

An experiment was conducted under the same conditions as the working example except for not inserting a rest time.

The results are likewise shown in Figures 1C (via diameter of 50 micrometers) and 1D (via diameter of 30 micrometers).

It can be seen that filling is improved by inserting a rest time.

## Claims

1. A method of electroplating a metal layer on a substrate comprising contacting the substrate with a metal electroplating bath and applying sufficient current density to deposit a desired metal layer, wherein the current density is applied for a cycle of 1 to 50 msec positive electrolysis time, 0.2 to 5 msec reverse electrolysis time and 0.1 to 20 msec rest time.

2. The method of Claim 1 wherein the metal electroplating bath is a copper electroplating bath.

3. The method of Claim 2 wherein the copper electroplating bath comprises copper sulfate.

4. The method of Claim 1 wherein the metal electroplating bath comprises a grain refiner.

5. The method of Claim 1 wherein the rest time is performed prior to the reverse electrolysis time.

6. The method of Claim 1 wherein rest time is performed after the reverse electrolysis time.

7. The method of Claim 1 wherein rest time is performed before and after the reverse electrolysis time.

8. The method of Claim 1 wherein the substrate is a printed circuit board.

9. The method of Claim 1 wherein the substrate is an integrated circuit substrate.

10. An electroplating method wherein a current is applied for a cycle of 1 to 50 msec positive electrolysis time, o.2 to 5 msec reverse electrolysis time and 0.1 to 20 msec rest time.
